# EUROPEAN PATENT APPLICATION

(11) **EP 1 602 626 A2**
(43) Date of publication of application: **07.12.2005**
(21) Application number: 05101102.1
(22) Date of filing: 15.02.2005
(51) Int. Cl.: B81C 1/00

(54) **Method and system for manufacturing laminated microstructures**

(30) Priority: 06.04.2004 JP 2004111768
(71) Applicant: MITSUBISHI HEAVY INDUSTRIES, LTD., Tokyo 108-8215 (JP); FUJI XEROX CO., LTD., Minato-ku, Tokyo (JP)
(72) Inventor: Hasegawa, Osamu Mitsubishi Heavy Industries. Ltd., Takasago-shi, Hyogo (JP); Tsuno, Takeshi Mitsubishi Heavy Industries. Ltd., Yokohama-shi, Kanagawa (JP); Yamada, Takayuki Fuji Xerox Co. Ltd, Ebina-shi, Kanagawa (JP); Takahashi, Mutsuya Fuji Xerox Co. Ltd, Ebina-shi, Kanagawa (JP); Asano, Shin Mitsubishi Heavy Industries. Ltd., Takasago-shi, Hyogo (JP); Tawara, Satoshi Mitsubishi Heavy Industries. Ltd., Yokohama-shi, Kanagawa (JP); Kinouchi, Masato Mitsubishi Heavy Industries. Ltd., Yokohama-shi, Kanagawa (JP); Goto, Takayuki Mitsubishi Heavy Industries. Ltd., Yokohama-shi, Kanagawa (JP)
(74) Representative: Henkel, Feiler & Hänzel

(57) **Abstract**

A manufacturing system for a microstructure includes a rough motion stage having preobtained positioning accuracy and a large stroke length, a fine motion stage disposed on the rough motion stage and having higher positioning accuracy than the rough motion stage and a small stroke length, and the like collectively as a stage device disposed in a vacuum container, laser length measuring machines for measuring a distance to a mirror disposed on the fine motion stage, a stage control device for driving the fine motion stage by a result of measurement by the laser length measuring machines, and the like collectively as a stage control unit, and a pressing rod 44 for holding a pressure-contacting target member disposed opposite to a pressure-contacted member held by the stage device and pressure-contacting and separating the members, a pressure-contacting drive mechanism for applying a pressure-contacting force to the pressing rod 44, and the like collectively as a pressure-contacting mechanism unit.

## Description

The entire disclosure of Japanese Patent Application No. 2004-111768 filed on April 6, 2004, including specification, claims, drawings and summary, is incorporated herein by reference in its entirety.

### BACKGROUND OF THE INVENTION

### 1. Field of the Invention

The present invention relates to a method of manufacturing a microstructure to be formed by laminating thin film members and a manufacturing system for the same.

### 2. Description of the Related Art

Along with the growth in fine processing technologies in recent years, numerous manufacturing methods for fabricating microstructures in three-dimensional forms have been developed. Among them, a laminate molding method of performing transfer and lamination onto a substrate by use of a room temperature bonding method is drawing attention. This is the method of forming respective cross-sectional forms in a lamination direction of a microstructure as thin film members on a substrate in a lump by use of a semiconductor manufacturing process, of peeling off the respective cross-sectional forms, i.e. the respective thin film members from the substrate, and of bonding them by use of the room temperature bonding method. Then, by repeating the peeling-off and the bonding, the thin film members are transferred and laminated, thus manufacturing the microstructure of a three-dimensional form (See Japan Patent No. 3161362, p. 7-9, Figs. 6-9).

Here, the room temperature bonding method is the bonding method utilizing phenomenon that surfaces of materials having clean atomic planes are chemically bonded even at a room temperature when oxides and impurities on the surfaces of the material are removed by irradiation of an ion beam or the like in vacuum. According to the room temperature bonding method, it is possible to obtain bonding strength equivalent to the bulk of a material without using adhesive.

In the above-described lamination molding method, it is a major issue in the future to improve form accuracy of the microstructure and to increase the number of laminations of the thin film members constituting the cross-sectional forms in the direction of lamination at the same time, and a concrete countermeasure technique is demanded. To be more precise, in the microstructure fabricated by the above-described laminate molding method, positioning accuracy of the respective thin film members in the direction of lamination is obtained by positioning accuracy among the respective thin film members at the time of lamination. This is greatly influenced by positioning accuracy of a stage configured to travel within a plane parallel to bonding surfaces of the laminated thin film members and to position the thin film members. Therefore, the stage for positioning the thin film members is required to have a high degree of positioning accuracy in the nanometer order.

Meanwhile, the thin film members constituting the respective cross-sectional forms in the direction of lamination of the microstructure arranged two-dimensionally on a substrate, for example. In order to achieve multiple lamination layers, multiple product types, or mass production, an area of arrangement of the thin film members is increased. Accordingly, a required travel amount of the stage is also increased in response to the size of the area of arrangement. Therefore, the stage for positioning is required to have a large stroke travel performance.

That is to say, in the above-described laminate molding method, the stage for positioning the thin film members is required to have a high degree of positioning accuracy and a large stroke travel performance in terms of the plane parallel to the bonding surfaces of the thin film members. Moreover, since the above-described laminate molding method is performed in high vacuum, the stage has to deal with high vacuum. In addition, since the respective thin film members are bonded together by applying certain pressure, the stage is required to have a high load bearing characteristic. As for concrete requested specifications, the stage is required to have the characteristics to meet all the requirements of high positioning accuracy in the nanometer order, a traveling stroke in a range from several tens of millimeters to several hundreds of millimeters, a high degree of vacuum at about 10⁻⁶ Pa, and a high load bearing characteristic of about several tons.

Today, the stage having high positioning accuracy includes the following types. However, these types have the following problems in light of application to the above-described laminate molding method.
1) Linear motor drive method
   The linear motor drive method requires an air slide guide in order to achieve positioning accuracy, and is therefore not usable in vacuum which is a bonding atmosphere.
2) Ultrasonic motor drive method
   The ultrasonic motor drive method can only achieve small thrust (maximum load). The method also causes abrasion of a friction drive unit and becomes a source of contamination of the bonding atmosphere.
3) Piezoelectric element / inchworm drive method
   This method can only achieve a small stroke and low traveling speed.

That is to say, there have been practically no positioning stages, which have high accuracy and a large stroke, satisfy high vacuum compatible and high load bearing specifications, and are easily applicable.

### SUMMARY OF THE INVENTION

The present invention has been made in consideration of the foregoing problems. It is an object of the present invention to provide a method of manufacturing a microstructure having high form accuracy, and to provide a manufacturing system for the same.

To solve the problems, claim 1 of the present invention provides a method of manufacturing a microstructure, comprising:
a positioning step of opposing bonding portions of a pressure-contacted member having a plurality of thin film members having any one of an arbitrary two-dimensional pattern and an arbitrary three-dimensional pattern and of a pressure-contacting target member arranged so as to face the pressure-contacted member;
a pressure-contacting step of pressure-contacting the thin film members to the pressure-contacting target member by pressure-contacting and separating means; and
a separating step of separating the thin film members toward the pressure-contacting target member by the pressure-contacting and separating means, and
wherein each thin film member is laminated sequentially on the pressure-contacting target member by repeating the positioning, pressure-contacting and separating steps, and
wherein the positioning step includes:
a motion step of moving any of the pressure-contacted member and the pressure-contacting target member to a target position by use of a first stage having a stroke enabling the first stage to travel across entire surfaces of the pressure-contacted member and the pressure-contacting target member;
a measuring step of measuring a position of any of the pressure-contacted member and the pressure-contacting target member, which is moved by the first stage, by measuring means capable of measuring the position at high accuracy, and of calculating an error correction value based on difference between the measured position and a target position; and
an error correction step of moving a second stage, which has a stroke equivalent to or greater than a range of positioning accuracy of the first stage, to the target position based on the calculated error correction value, and of correcting a positioning error of the first stage.

To solve the problems, claim 2 of the present invention provides the method of manufacturing a microstructure, in which in the error correction step, the positioning error of the first stage is corrected by use of the second stage disposed so as to be capable of moving at least one of the pressure-contacted member and the pressure-contacting target member.

To solve the problems, claim 3 of the present invention provides the method of manufacturing a microstructure, in which in the error correction step, the second stage is moved by use of a piezoelectric element operating as an actuator for driving a movable portion of the second stage and by use of an elastic guide for guiding the movable portion thereof.

To solve the problems, claim 4 of the present invention provides the method of manufacturing a microstructure, in which in the error correction step, the second stage is inchworm-driven, thereby positioning the second stage accurately.

To solve the problems, claim 5 of the present invention provides the method of manufacturing a microstructure, in which in the measuring step, by measuring a length up to a mirror by use of a laser length measuring machine measuring a length using a laser beam and by use of the mirror moving so as to follow any of the pressure-contacted member and the pressure-contacting target member, a position of any of the pressure-contacted member and the pressure-contacting target member, which is moved by the first stage, is measured.

To solve the problems, claim 6 of the present invention provides the method of manufacturing a microstructure, in which in the measuring step, before a lamination of the pressure-contacted member or during the lamination of the pressure-contacted member, a degree of flatness of a plane of the mirror is measured, a flatness correction value is obtained based on the degree of flatness of the mirror relative to an ideal plane of the mirror, and the error correction value is corrected by use of the flatness correction value, thereby preventing deviation between the thin film members due to form accuracy of the mirror.

To solve the problems, claim 7 of the present invention provides the method of manufacturing a microstructure, in which in the positioning step, a position of the pressure-contacting and separating means for holding any of the pressure-contacted member and the pressure-contacting target member is measured,
during the lamination, a lamination correction value is calculated based on an amount of deviation from a position of the pressure-contacting and separating means in a previous lamination, and
the error correction value is corrected by use of the lamination correction value, thereby preventing deviation between the thin film members due to repeatedly positioning accuracy of the pressure-contacting means.

To solve the problems, claim 8 of the present invention provides the method of manufacturing a microstructure, in which the positioning step includes an alignment step in which a setting position of any one of the pressure-contacted member and the pressure-contacting target member relative to a reference position for positioning the first and second stages is measured, and a reference position correction value for correcting the setting position to the reference position is calculated.

To solve the problems, claim 9 of the present invention provides the method of manufacturing a microstructure, in which in the alignment step, an alignment mark formed in any one of the pressure-contacted member and the pressure-contacting target member is detected, and the setting position is obtained based on a detected position of the alignment mark.

To solve the problems, claim 10 of the present invention provides the method of manufacturing a microstructure, in which in the alignment step,
a minute film pattern formed by use of a photolithographic technique is used as the alignment mark, and
an optical system capable of enlarging the alignment mark into an arbitrary size to project the enlarged alignment mark, photographing means for photographing the alignment mark through the optical system, and image processing means for recognizing the detection portion of the alignment mark from an image photographed by the photographing means are used.

To solve the problems, claim 11 of the present invention provides the method of manufacturing a microstructure, in which a substrate in which any one of a plurality of arbitrary two-dimensional patterns and a plurality of arbitrary three-dimensional patterns are formed is used as the pressure-contacting target member.

To solve the problems, claim 12 of the present invention provides the method of manufacturing a microstructure, in which a substrate in which any one of a plurality of arbitrary two-dimensional patterns and a plurality of arbitrary three-dimensional patterns are formed is used as the pressure-contacted member.

To solve the problems, claim 13 of the present invention provides the method of manufacturing a microstructure, in which any of the pressure-contacted member and the preeure-contacting target member is rendered replaceable.

To solve the problems, claim 14 of the present invention provides the method of manufacturing a microstructure, in which in the pressure-contacting step, an operation accuracy of a pressure-contacting shaft is secured by use of the pressure-contacting shaft for holding any one of the pressure-contacted member and the pressure-contacting target member and by use of guiding means having one or a plurality of linear motion guiding mechanisms disposed parallel to a pressure-contacting direction of the pressure-contacting shaft, so as to suppress movement of the pressure-contacting shaft in a direction perpendicular to a pressure-contacting direction.

To solve the problems, claim 15 of the present invention provides a manufacturing system for a microstructure, comprising:
pressure-contacting and separating element for pressure-contacting a pressure-contacted member having a plurality of thin film members, each having any of an arbitrary two-dimensional pattern and an arbitrary three-dimensional pattern, to a pressure-contacting target member arranged so as to face the pressure-contacted member, and for separating the thin film members toward the pressure-contacting target member; and
positioning element for performing positioning of the pressure-contacted member and the pressure-contacting target member,
wherein bonding portions of the pressure-contacted member and of the thin film members are opposed to one another by the positioning element, the thin film members are pressure-contacted to the pressure-contacting target element by the pressure-contacting and separating element, and the pressure-contacting and separating element separates from the pressure-contacting target element, thus laminating the thin film members on the pressure-contacting target member, and
wherein the positioning element comprises:
a first stage having a stroke enabling the first stage to travel across entire surfaces of the pressure-contacted member and the pressure-contacting target member facing each other;
a second stage having a stroke equivalent to or greater than a range of positioning accuracy of the first stage;
measuring element capable of measuring a position of at least one of the pressure-contacted member and the pressure-contacting target member at high accuracy; and
positioning controlling element for allowing the measuring element to measure the position of any of the pressure-contacted member and the pressure-contacting target member moved by the first stage, for calculating an error correction value based on a difference between the measured position and a target position, and for moving the second stage to the target position by use of the calculated error correction value, thus correcting a positioning error of the first stage.

To solve the problem, claim 16 of the present invention provides the manufacturing system for a microstructure, in which at least one of the pressure-contacted member and the pressure-contacting target member is disposed movably in the second stage.

To solve the problem, claim 17 of the present invention provides the manufacturing system for a microstructure, in which the second stage includes a piezoelectric element for driving a movable portion thereof and an elastic guide for guiding the movable portion.

To solve the problem, claim 18 of the present invention provides the manufacturing system for a microstructure, in which the second stage is inchworm-driven.

To solve the problem, claim 19 of the present invention provides the manufacturing system for a microstructure, in which the measuring element includes a laser length measuring machine measuring a length using a laser beam and a mirror moving so as to follow any of the pressure-contacted member and the pressure-contacting target member, and the measuring element measurers a length up to the mirror, thus measuring a position of any of the pressure-contacted member and the pressure-contacting target member, which is moved by the first stage.

To solve the problem, claim 20 of the present invention provides the manufacturing system for a microstructure, in which before a lamination of the pressure-contacted member or during the lamination of the pressure-contacted member, the measuring element measures a degree of flatness of a plane of the mirror, obtains a flatness correction value based on the degree of flatness of the mirror relative to an ideal plane of the mirror, and corrects the error correction value by use of the flatness correction value.

To solve the problem, claim 21 of the present invention provides the manufacturing system for a microstructure, in which the positioning element includes a lamination correction element which measures a position of the pressure-contacting and separating element for holding any of the pressure-contacted member and the pressure-contacting target member by the measuring element, calculates a lamination correction value, during the lamination, based on an amount of deviation from a position of the pressure-contacting and separating element in a previous lamination, and corrects the error correction value by use of the lamination correction value.

To solve the problem, claim 22 of the present invention provides the manufacturing system for a microstructure, in which alignment element is provided, which measures a setting position of any one of the pressure-contacted member and the pressure-contacting target member relative to a reference position for positioning the first stage and the second stage, and calculates a reference position correction value for correcting the setting position to the reference position.

To solve the problem, claim 23 of the present invention provides the manufacturing system for a microstructure, in which the alignment element detects an alignment mark formed in any one of the pressure-contacted member and the pressure-contacting target member, and obtains the setting position based on a detection position of the alignment mark.

To solve the problem, claim 24 of the present invention provides the manufacturing system for a microstructure, in which the alignment mark is formed as a minute film pattern formed by use of a photolithographic technique, and
the alignment element includes an optical system capable of enlarging the alignment mark into an arbitrary size to project the enlarged alignment mark, photographing element for photographing the alignment mark through the optical system, and image processing element for recognizing the detection portion of the alignment mark from an image photographed by the photographing element.

To solve the problem, claim 25 of the present invention provides the manufacturing system for a microstructure, wherein a substrate in which any one of a plurality of arbitrary two-dimensional patterns and a plurality of arbitrary three-dimensional patterns are formed is used as the pressure-contacted member.

To solve the problems, claim 26 of the present invention provides the manufacturing system for a microstructure, in which a substrate in which any one of a plurality of arbitrary two-dimensional patterns and a plurality of arbitrary three-dimensional patterns are formed is used as the pressure-contacting target member.

To solve the problems, claim 27 of the present invention provides the manufacturing system for a microstructure, in which any one of the pressure-contacted member and the pressure-contacting target member is rendered replaceable.

To solve the problems, claim 28 of the present invention provides the manufacturing system for a microstructure, in which the pressure-contacting and separating element includes a pressure-contacting shaft for holding any one of the pressure-contacted member and the pressure-contacting target member, and guiding element composed of one or a plurality of linear motion guiding mechanisms disposed parallel to a pressure-contacting direction of the pressure-contacting shaft, so as to suppress movement of the pressure-contacting shaft in a direction perpendicular to a pressure-contacting direction.

According to the present invention, a stage device (the positioning element) loading a plurality of thin film members (the pressure-contacted member) constituting a microstructure can satisfy all requirements of high load bearing, high vacuum compatibility, high-accuracy, and a large-stroke characteristics, and such a stage device is easily applicable. Therefore, it is possible to perform control at high positioning accuracy while maintaining a large traveling stroke. In this way, it is possible to form a microstructure into an arbitrary three-dimensional shape and to achieve multiple layers, multiple product types, and mass production.

### BRIEF DESCRIPTION OF THE DRAWINGS

Fig. 1 is a view showing a configuration of a manufacturing system for a microstructure according to an embodiment of the present invention.
Figs. 2A and 2B are views showing a configuration of a fine motion stage in the manufacturing system for a microstructure shown in Fig. 1.
Figs. 3A to 3C are views showing a configuration of a θ stage in the manufacturing system for a microstructure shown in Fig. 1.
Fig. 4 is a block diagram for explaining control of the rough motion stage and the fine motion stage in the manufacturing system for a microstructure shown in Fig. 1.
Fig. 5 is a histogram of a positioning error of a microstructure applying the manufacturing system for a microstructure shown in Fig. 1.

### DETAILED DESCRIPTION OF PREFERRED EMBODIMENT

A manufacturing system for a microstructure according to the present invention is configured to bond and laminate a plurality of thin film members and the like and thereby to manufacture a microstructure, by element of positioning the plurality of thin film members having an arbitrary two-dimensional pattern or three-dimensional pattern, a substrate including formation of a plurality of arbitrary two-dimensional patterns or three-dimensional patterns or the like (a pressure-contacted member) relative to a pressure-contacting target member to be disposed opposite, then performing pressure-contacting and separating, and then repeating these steps.

In the manufacturing system for a microstructure according to the present invention, a stage device is used to obtain a high degree of positioning accuracy, in which, on a large-stroke rough motion stage (a first stage) having preobtained positioning accuracy there is disposed a small-stroke fine motion stage (a second stage) having a higher degree of positioning accuracy than the rough motion stage.

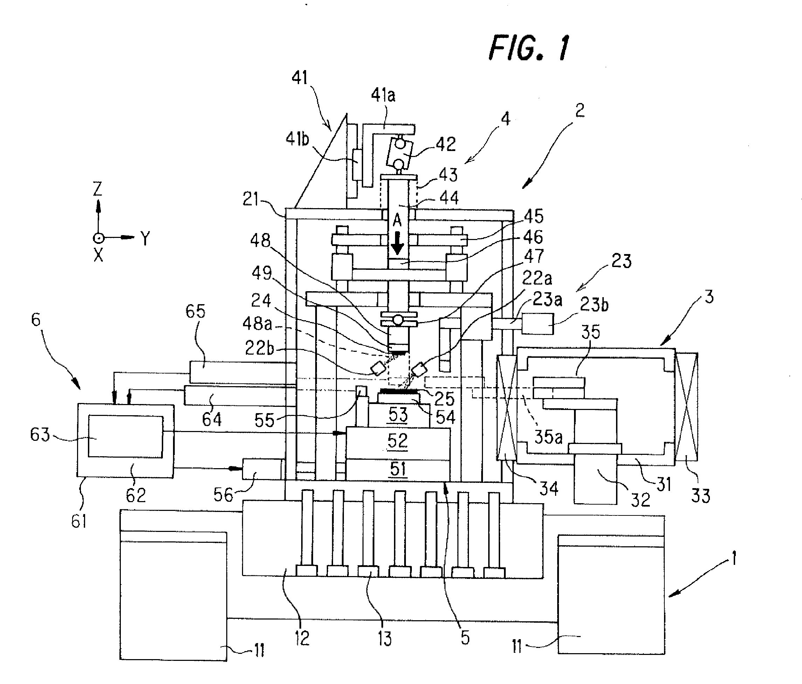

When bonding the thin film members constituting respective cross-sectional forms of the microstructure in a lamination direction, the rough motion stage is firstly moved to a target position. However, since the rough motion stage had limitation in positioning accuracy of a driving control system in order to ensure given traveling speed and a large stroke, the rough motion stage could not satisfy positioning accuracy in the nanometer order which is required for fabricating the microstructure. Accordingly, in the present invention, a large stroke and a high degree of positioning accuracy are obtained by combining a fine motion stage having a higher degree of positioning accuracy with the rough motion stage and moving the fine motion stage to the target position so as to correct a positioning error of the rough motion stage relative to the target position. In this case, the fine motion stage only needs to have a stroke at least sufficient for correcting the positioning error of the rough motion stage, or in other words, a stroke equivalent to or greater than a range of the positioning accuracy of the rough motion stage. A manufacturing system for a microstructure using the stage device having the above-described features will be described in detail with reference to Fig. 1 to Fig. 5.

Fig. 1 is a view showing a configuration of a manufacturing system for a microstructure according to an embodiment of the present invention.

As shown in Fig. 1, the manufacturing system for a microstructure according to the present invention principally includes a support table unit 1 which is a base portion of the manufacturing system, a chamber unit 2 supported on the support table unit 1, a conveying unit 3 for conveying a pressure-contacting target member 24 and a pressure-contacted member 25 to the chamber unit 2, a pressure-contacting mechanism unit 4 (pressure-contacting and separating element) for bonding the pressure-contacting target member 24 and the pressure-contacted member 25 conveyed to the chamber unit 2, a stage device 5 for holding the pressure-contacted member 25 conveyed to the chamber unit 2, and a stage control unit 6 (positioning element) for controlling a position of the stage device 5.

Although this embodiment adopts a layout in which the pressure-contacting target member 24 is held on the pressure-contacting mechanism unit 4 side and the pressure boded member 25 is held on the stage device 5 side so as to oppose the both members to each other, for example. However, it is possible to adopt a layout in which the pressure-contacting target member 24 is held on the stage device 5 and the pressure-contacted member 25 is held on the pressure-contacting mechanism unit 4. In this embodiment, as the pressure-contacted material 25, it is optimal to apply a plurality of two-dimensionally arranged thin film members each having an arbitrary two-dimensional pattern or an arbitrary three-dimensional pattern, a substrate including formation of a plurality of arbitrary two-dimensional patterns or arbitrary three-dimensional patterns, and the like. In addition, the pressure-contacting target member 24 may consist of a single member, a plurality of arbitrary two-dimensionally arranged members, and the like.

The support table unit 1 includes a plurality of vibration removing mechanisms 11 for eliminating influences of vibration from outside, a highly rigid surface plate 12 supported by the plurality of vibration removing mechanisms 11 and establishing a basis for a setting position of the chamber unit 2, and a plurality of bolts 13 for fastening a bottom of a vacuum container 21 constituting the chamber unit 2 to the surface plate 12 at a fine pitch from a rear surface of the surface plate 12. By fastening a bottom surface of the vacuum container 21 to the surface plate 12 from the rear surface thereof at a fine pitch, deformation of the bottom surface of the vacuum container 21 is suppressed upon evacuation. Moreover, displacement of instruments supported on the bottom surface of the vacuum container 21 and required for the laminate molding method, such as the stage device 5, is also suppressed to avoid adverse affects on high accuracy positioning.

The chamber unit 2 includes the vacuum container 21 which can achieve a high degree of vacuum (about 10⁻⁶ Pa) by use of an unillustrated vacuum pump. The chamber unit 2 includes the instruments required for the laminate molding method inside the vacuum container 21, such as part of the pressure-contacting mechanism unit 4, the stage device 5 for holding the pressure-contacted member 25, and fast atom bombardment (FAB) devices 22a and 22b, for cleaning and activating bonding surfaces of the pressure-contacting target member 24 and of the thin film members 25.

The stage device 5 is disposed in a lower part inside the vacuum container 21. To be more precise, the stage device 5 includes: a rough motion stage 51 provided at the bottom surface of the vacuum container 21, which has a large stroke and is movable in an XY plane direction; a fine motion stage 52 provided on the rough motion stage 51, which has a high degree of positioning accuracy in the nanometer order and is movable in the XY plane direction; a θ stage 53 which is provided on the fine motion stage 52 and is movable in a θ direction (a direction of rotation within the XY plane); and an electrostatic chuck 54, provided on the θ stage 53, for holding the pressure-contacted member 25. A mirror 55 having a high degree of flatness is provided on the fine motion stage 52 so as to extend in the XY direction, which is used for measuring a position of the pressure-contacted member 25.

The rough motion stage 51 includes a motor 56, which is disposed outside the vacuum container 21, and which generates a driving force; a ball screw for transmitting the driving force of the motor 56 to the rough motion stage 51; a cross roller guide for guiding the rough motion stage 51 to the driving direction; and the like. The rough motion stage 51 has a large stroke which can allow the entire surface of the pressure-contacted member 25, and which is formed by two-dimensionally arranging the plurality of thin film members to face the pressure-contacting target member 24, and is driven in the XY direction at speed equal to or above a preobtained value. These rough motion stage 51, the fine motion stage 52, the θ stage 53, and the like are compatible to high vacuum, highly rigid (having high load bearing characteristics), and resistant to a high pressure-contacting force. Here, in this embodiment, the configuration is adopted, in which the fine motion stage 52 is provided on the rough motion stage 51 and the pressure-contacted member 25 is disposed on the fine motion stage 52 side. However, the present invention shall not be limited to the above-described configuration. For example, it is possible to provide any one of the stages or both of the stages on the pressure-contacting target member 24 side.

A holding plane for allowing the electrostatic chuck 54 to hold the pressure-contacted member 25 is formed to have a high degree of flatness. By holding the pressure-contacted member 25 with the electrostatic chuck 54, the pressure-contacted member 25 sticks to the holding surface so as to conform with it. In this way, the surface of the pressure-contacted member 25 can also retain a high degree of flatness. Here, by fitting the pressure-contacted member 25 to a substrate made of a metal material which is attracted by a magnetic force while maintaining a high degrees of flatness, it is also possible to use a magnetic chuck instead of the electrostatic chuck 54.

The pressure-contacted member 25 is disposed on the electrostatic chuck 54 while using a reference position in terms of drive coordinates (such as an origin of the drive coordinates or the position of the mirror 55) on the stage device 5 (the rough motion stage 51, the fine motion stage 52, and the θ stage 53) side as a reference. However, an actual setting position of the pressure-contacted member 25 is apt to be deviated from the preobtained setting position. Moreover, a high degree of positioning accuracy in the nanometer order is required for the manufacturing system for a microstructure according to the present invention. Therefore, it is necessary to provide element for correcting the setting position of the pressure-contacted member 25.

Accordingly, the manufacturing system for a microstructure of the present invention is provided with an alignment mechanism 23 (alignment element). The alignment mechanism 23 includes an optical system 23a provided so as to enlarge and project the surface of the stage device 5, a charge-coupled device (CCD) camera 23b (photographing element) for photographing the surface of the stage device 5 through the optical system 23a, and an image processing device (image processing element) for recognizing an image photographed by the CCD camera 23b and performing computation processing. The alignment mechanism 23 calculates the setting position of the pressure-contacted member 25 by photographing an alignment mark provided on the surface of the pressure-contacted member 25 with the CCD camera 23b, recognizing the alignment mark out of the photographed image, and detecting the position of the alignment mark. Then, the alignment mechanism 23 is configured to align the pressure-contacted member 25 by measuring amounts of deviation in the X, Y, and θ directions of the setting position of the pressure-contacted member 25 relative to the reference position of the drive coordinates on the stage device 5 side, calculating reference position correction values in response to the amounts of deviation to perform correction, and tuning the setting position of the pressure-contacted member 25 to the drive coordinates on the stage device 5 side. Alternatively, it is also possible to reset the pressure-contacted member 25 to an appropriate setting position in response to the reference position correction values. Accordingly, even when the setting position of the pressure-contacted member 25 is deviated, it is possible to position the pressure-contacted member 25 in the target position by the alignment mechanism 23 at high accuracy.

Here, the alignment mark is made of a minute film pattern formed by use of a photolithographic technique. It is possible to form the alignment mark accurately relative to the position of arrangement of the thin film members in term of form accuracy and positioning accuracy. It is possible to provide a similar alignment mark on the stage device 5 as well, and to use this alignment mark as the reference position in terms of the drive coordinates of the stage device 5.

The conveying unit 3 includes a load lock chamber 31 which can reach the same degree of vacuum as the vacuum container 21 by use of the unillustrated vacuum pump; a conveying mechanism 32 for conveying the pressure-contacted member 25 disposed inside the load lock chamber 31 onto the stage device 5 in the vacuum container 21; a load lock door 33 which is an opening and closing door between the load lock chamber 31 and ambient air, the load lock door 33 sealing the load lock chamber 31 when being closed and maintaining the degree of vacuum therein; and a gate door 34 disposed between the vacuum container 21 and the load lock chamber 31. The gate door 34 opens its door when conveying the pressure-contacted member 25, thus allowing the load lock chamber 31 to be communicated with the vacuum container 21 and permitting conveyance of the pressure-contacted member 25. When opening the load lock chamber 31 to the ambient air, the gate door 34 closes its door to maintain the degree of vacuum inside the vacuum container 21.

The conveying mechanism 32 includes an arm 35 which can extend and contract by use of a plurality of joints. By extending and contracting the arm 35, the conveying mechanism 32 can move a tip portion thereof for holding the pressure-contacted member 25 in XYZ-θ directions. For example, in a standby mode or when the conveying mechanism 32 is not in operation, the conveying mechanism 32 stands by while folding the arm portion as the arm 35 illustrated in Fig. 1. On the other hand, when disposing the pressure-contacted member 25 on the stage device 5 in the vacuum container 21, the conveying mechanism 32 operates the arm 35 to extend toward the stage device 5 like an arm 35a illustrated by dotted lines in Fig. 1. Meanwhile, by placing a plurality of substrates, in which the plurality of thin film members are formed, in the load lock chamber 31, it is possible to convey the respective substrates sequentially into the vacuum container 21. Moreover, by sequentially laminating the thin film members of the respective substrates while changing the substrates, it is possible to perform lamination of the thin film members of the plurality of substrates continuously without setting the degree of vacuum inside the load lock chamber 31 back to the ambient air. In this way, it is possible to achieve multiple layers, multiple product types, or mass production of microstructures. Here, in addition to the pressure-contacted member, it is also possible to render the pressure-contacting target member conveyable by the conveying mechanism 32 and to render a plurality of pressure-contacting target members changeable.

The pressure-contacting mechanism unit 4 is disposed above the chamber unit 2 and on an upper part inside the vacuum container 21. To be more precise, above the chamber unit 2 the pressure-contacting mechanism unit 4 includes a pressure-contacting drive mechanism 41 supported by a top plate portion of the vacuum container 21 and configured to generate the pressure-contacting force, a universal joint 42 connected to the pressure-contacting drive mechanism 41 as freely movable in the direction of connection and configured to transmit the pressure-contacting force downward in a vertical direction, and a vertically movable pressing rod 44 (a pressure-contacting shaft) connected to the universal joint 42 while penetrating the top plate of the vacuum container 21 and extending from the inside to the outside. At the time of pressure-contacting, the pressure-contacting force is generated in the direction as indicated by an arrow A in Fig. 1, and the pressure-contacting target member 24 and the pressure-contacted member 25 are bonded to each other. Meanwhile, a bellows 43 is provided between a through hole portion of the top plate of the vacuum container 21 for allowing the pressing rod 44 to penetrate therethrough and the pressing rod 44, whereby the pressure-contacting mechanism unit 4 can maintain the vacuum inside the vacuum container 21.

Meanwhile, on the upper part inside the vacuum container 21, the pressure-contacting mechanism 4 includes a guiding mechanism 45 (guiding element) fixed to a bottom of the vacuum container 21 with a plurality of pillars and configured to guide the pressing rod 44, a piezoelectric dynamometer 46 for measuring the pressure-contacting force toward the stage device 5, an angle adjusting mechanism 47 connected to a tip portion of the pressing rod 44 and configured to set a bonding surface of the pressure-contacting target member 24 parallel to a bonding surface of the pressure-contacted member 24 held on the stage device 5 side, and a magnetic chuck 48 provided at a tip portion of the angle adjusting mechanism 47 and configured to fit a holder 49 for holding the pressure-contacting target member 24. The guiding mechanism 45 includes one or a plurality of linear motion guiding mechanisms arranged parallel to the pressing rod 44. The guiding mechanism 45 suppreses motion in a plane direction perpendicular to the pressure-contacting direction A by guiding motion of the pressing rod 44, thus ensuring motion accuracy of the pressing rod 44. As the linear motion guiding mechanism, for example, a vacuum compatible guide post type high precision linear guide is used, which can achieve high rigidity and high accuracy. Here, the layout of the respective constituents of the pressure-contacting mechanism unit 4 are not limited to the above-described configuration as long as the pressure-contacting mechanism unit 4 can retain the equivalent functions.

Here, the pressure-contacting drive mechanism 41 includes a rod fitting jig 41a connected to the pressing rod 44 by the universal joint 42, a pressure-contacting and separating motor which is an actuator for providing the driving force for pressure-contacting and separation, a ball screw for transmitting the driving force of the pressure-contacting and separating motor to the rod fitting jig 41a, and a cross roller guide 41b for guiding the rod fitting jig 41a in the driving direction (illustration of some of these constituents is omitted). For example, the vacuum container 21 has a fear of deformation in the course of evacuation, and the position of the pressing rod 44 on the vacuum container 21 side may be displaced by deformation of the vacuum container 21. Moreover, the position of the pressing rod 44 on the vacuum container 21 side may be also displaced by an assembly error of the pressure-contacting mechanism unit 4, or to be more precise, a mechanical assembly error caused between the pressing rod 44 to be guided by the guiding mechanism 45 and the rod fitting jig 44a to be guided by the cross roller guide 41b. Therefore, the present invention adopts a configuration to retain high positioning accuracy by absorbing an amount of deviation between the rod fitting jig 41a and the pressing rod 44 by the universal joint 42 and thereby canceling a force in a horizontal direction which is transmitted to the pressing rod 44 upon occurrence of deviation.

The stage control unit 6 includes a stage control device 61 to perform positioning control of the stage device 5. The stage control device 61 principally includes a main control unit 62 for controlling the rough motion stage 51, the θ stage 53, the electrostatic chuck 54, and the like of the stage device 5, and an error correcting unit 63 for controlling the fine motion stage 52. When moving the rough motion stage 51, a moving position instruction is given by the main control unit 62 to the motor 56 to move the rough stage 51. In this case, the moving position is monitored by a rotary encoder of the motor 56, and the rough motion stage 51 is moved to the moving position. On the contrary, the moving position of the fine motion stage 52 is controlled by use of a different route.

To be more precise, two laser length measuring machines 64 (measuring element) are provided along the XY direction beside the vacuum container 21. Accordingly, it is possible to measure a current position of the mirror 55 by irradiating laser beam from the laser length measuring machines 64 onto the mirror 55 provided on the fine motion stage 52. Here, in order to perform measurement at high accuracy, it is preferable to use an interferometric type laser length measuring machine configured to measure length by use of interferometry of a laser beam, for example. The position of the mirror 55 thus measured is sent to the error correcting unit 63 as feedback, and the moving position instruction is given to the fine motion stage 52 based on the feedback to move the fine motion stage 52 to the target position. Here, the position of the mirror 55 is always constant with respect to the fine motion stage 52, and the setting position of the pressure-contacted member 25 relative to the drive coordinates of the stage device 5 can be calculated by use of the alignment device 23. Therefore, the position of the pressure-contacted member 25 can be calculated by measuring the current position of the mirror 55. Accordingly, it is possible to calculate a difference between the current position and the target position of the pressure-contacted member 25 (i.e. a positioning error of the rough motion stage 51) and to calculate an error correction value to move the pressure-contacted member 51 to the target position based on this difference. Hence, the pressure-contacted member 25 is moved to the target position by giving this error correction value to the fine motion stage 52.

Meanwhile, two laser length measuring machines 65 for measuring an amount of displacement of the tip portion of the pressing rod 44 in terms of the horizontal direction are provided along the XY direction beside the vacuum container 21. Here, the position of the pressing rod 44 in the horizontal direction is previously measured when pressure-contacting the thin film member of the pressure-contacted member 25 corresponding to a first layer. When pressure-contacting the thin film members of the pressure-contacted member corresponding to a second layer and thereafter, the position of the pressing rod 44 at the time of previous pressure-contacting and the current position of the pressing rod 44 are compared, thus calculating a lamination correction value for correcting deviation between the thin film members to be laminated by use of an amount of deviation obtained by comparison. Thereafter, the lamination correction value is added to the error correction value relative to the fine motion stage 51 so as to correct the moving position of the fine motion stage 51. In this case, a mirror similar to the one placed on the fine motion stage 52 is provided on a plane in the XY direction of the holder unit 49 or the like, i.e. on a plane facing the two laser length measuring machines 65. Accordingly, the position of the tip portion of the pressing rod 44 is measured by measuring the position of the mirror. In other words, measurement of the position of the tip portion of the pressing rod 44 is equivalent to measurement of the position of the pressure-contacting target member 24 to be fitted to a preobtained position at the tip of the pressing rod 44. Therefore, by constantly monitoring the position of the pressure-contacting target member 24 in the course of pressure-contacting, it is possible to eliminate positional deviation among the layers attributable to repetitive positioning accuracy of the pressing rod 44 per se.

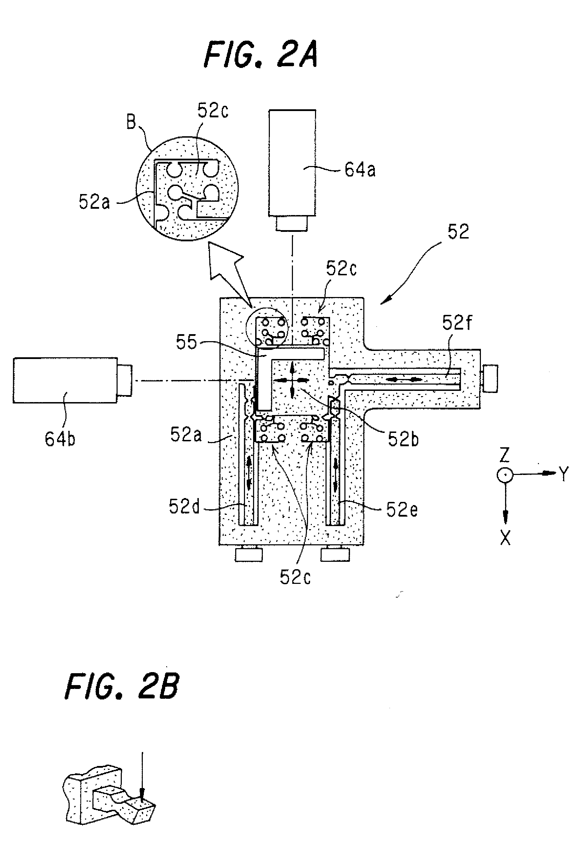

Next, the configuration of the fine motion stage 52 will be described further in detail with reference to Figs. 2A and 2B.

Here, Fig. 2A is a top plan view of the fine motion stage 52, and illustration of the θ stage 53, the electrostatic chuck 54, and the like is omitted to facilitate understanding.

The fine motion stage 52 includes: a frame 52a (a fixed portion) fixed to the rough motion stage 51; a stage 52b (a movable portion) surrounded by the frame 52a and disposed so as to be movable; a plurality of hinge portions 52c disposed on four corners of the table 52b to support the table 52b movably; two piezoelectric elements 52d and 52e extending in the X direction, each of which has one end connected to the frame 52a and the other end connected to the table 52b; and a piezoelectric element 52f extending in the Y direction, which has one end connected to the frame 52a and the other end connected to the table 52b. In addition, the rough motion stage 52 includes the mirror 55 having perpendicularly arranged two planes on the table 52b. The piezoelectric elements 52d, 52e, and 52f are disposed in elongated groove portions provided on the frame 52a, and the groove portions function as guides for the piezoelectric elements 52d, 52e, and 52f.

For example, when the table 52b is moved in the X direction, voltages in synchronization with the piezoelectric elements 52d and 52e are applied to the piezoelectric elements 52d and 52e. On the contrary, when the table 52b is moved in the Y direction, a voltage is applied to the piezoelectric element 52f. The table 52b is moved by extending and contracting the piezoelectric elements 52d, 52e, and 52f operating as actuators. These piezoelectric elements 52d, 52e, and 52f may be configured to perform so-called inchworm drive. In this way, the piezoelectric elements 52d, 52e, and 52f can be configured to hold positions after expansion and contraction at high accuracy. Here, when moving the table 52b, the position of the table 52b is accurately monitored by the two laser length measuring machines 64a and 64b disposed along the XY direction.

As shown in an enlarged view of Fig. 2B, the hinge portion 52c has a unique shape combining a plurality of notched springs functioning as elastic guides. By providing a plurality of arc notches, the hinge portion 52c is rendered independently deformable in different directions. In other words, the hinge portion 52c is rendered deformable so as not to incur adverse effects between the motion in the X direction and the motion in the Y direction of the table 52b. Moreover, it is also possible to tilt the table 52b slightly in the θ direction by applying different voltages independently to the piezoelectric elements 52d and 52e. The hinge portion 52c may be made of a low thermal expansion alloy. In this way, it is possible to form the fine motion stage 52 which can suppress adverse effects of thermal expansion and achieve high positioning accuracy.

In addition, the hinge portion 52c utilizes rigidity of the notched springs to support the table 52b in the direction against the pressure-contacting force of the pressure-contacting mechanism unit 4. When the pressure-contacting force equal to or above a preobtained value is applied to the table 52b, deformation of the hinge portion 52c equivalent to rigidity of the notched springs is restrained by contact with an upper surface of the rough motion stage 51 on the bottom surface side of the table 52b. In this way, it is possible to suppress inclination between the bonding surfaces of the pressure-contacting target member 24 and of the pressure-contacted member 25.

The mirror 55 includes two large planes respectively in the X direction and the Y direction, which are larger than the size of the region where the pressure-contacted member 25 is disposed. Therefore, measurement positions of the laser length measuring machines 64a and 64b on the surface of the mirror 55 vary depending on the moving positions of the rough motion stage 51 and the fine motion stage 52. Here, in order to measure the moving position of the mirror 55 at high accuracy, it is necessary to consider a degree of flatness of the two planes of the mirror 55. Accordingly, the present invention adopts a configuration to measure the degree of flatness of the two planes of the mirror 55 before lamination (off process) or in the course of lamination (in process), to calculate a flatness correction value by use of the degree of flatness of the two planes of the mirror 55 relative to an ideal degree of flatness of the two planes thereof, and to correct the moving position of the fine motion stage 52 by adding the flatness correction value to the error correction value for the fine motion stage 52. Therefore, by performing the above-described correction, it is possible to correct the positional deviation between the layers attributable to the form accuracy of the mirror 55.

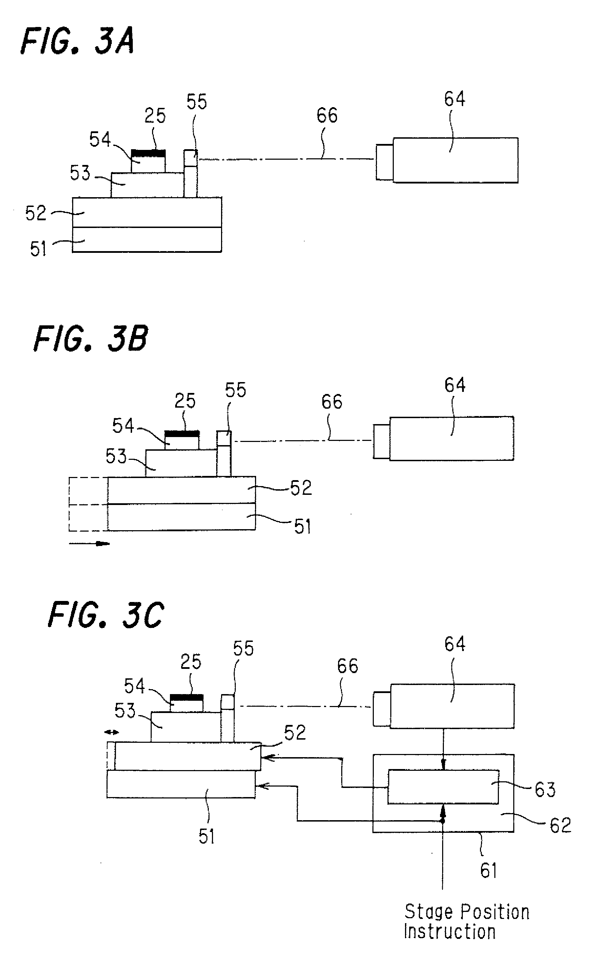

Next, a manufacturing method for a microstructure using the above-described manufacturing system will be described together with a controlling method (a positioning process) for the rough motion stage 51 and the fine motion stage 52 with reference to Fig. 3A to Fig. 4.

### (1) Fabrication process for pressure-contacted member and pressure-contacting target member

Prior to manufacturing a microstructure with the manufacturing system, the pressure-contacting target member 24 and the pressure-contacted member 25 are fabricated in advance. To be more precise, a microstructure having a desired three-dimensional structure is broken down into a plurality of cross-sectional forms in the direction of lamination by use of three-dimensional computer-aided design (CAD), and then a mask is fabricated by two-dimensionally arranging and patterning the respective cross-sectional forms. Then, a film is formed on a substrate by use of a desired material and the film is processed into the shapes patterned on the mask by use of the photolithographic technique. In this way, a plurality of two-dimensionally arranged thin film members are formed in a lump on the substrate. To facilitate peeling of the thin film members, a mold releasing layer made of polyimide or the like is formed below the thin film members. In addition, in the pressure-contacting target member, a convex mesa-shaped portion is formed by use of a desired material. The microstructure is formed by laminating the plurality of thin film members on a mesa-shaped portion of the pressure-contacting target member.

Here, bonding strength by pressure-contacting is influenced by surface roughness of the bonding surfaces of the pressure-contacting target member 24 and of the pressure-contacted member 25. Accordingly, it is possible to avoid voids on bonding boundaries and thereby to obtain better bonding strength by planarizing the surfaces to the surface roughness of about Ra= 1 nanometer with a chemical mechanical polishing (CMP) technique and the like. Moreover, by reducing the thickness of the thin film members, it is possible to improve accuracy of resolution not only in the XY-axis direction but also in the Z-axis direction, that is, resolution of the shape in the direction of the height (lamination) of the microstructure in the three-dimensional shape. In this case, since the soft mold releasing layer made of polyimide or the like exists under the thin film members, the thin film members may be buried in the mold releasing layer when pressure-contacting the thin film members, and transferability may be degraded as a consequence. Accordingly, in this case, a portion of the mold releasing layer not having the thin film members thereon is etched by use of reactive gas or the like, so that the thin film members are lifted up by platforms of the mold releasing layer therebelow. In this way, the thin film members are avoided from being buries in the surrounding mold releasing layer. As described above, in order to obtain fine form accuracy of the microstructure in the nanometer order, it is preferable to apply semiconductor manufacturing techniques, which facilitates fine processing, to the method of fabricating the pressure-contacted member and the pressure-contacting target member. However, it is also possible to use other manufacturing method depending on the form accuracy.

### (2) Conveying process for pressure-contacted member and pressure-contacting target member

The pressure-contacted member 25 including the plurality of thin film members is placed on the stage device 5 by use of the conveying unit 3 of the manufacturing system. Meanwhile, the pressure-contacting target member 24 may be fitted to the holder unit 49 at the tip of the pressing rod 44 by use of the conveying unit 3 of the manufacturing system, or fitted to the holder unit 49 in advance.

### (3) Positioning process for thin film members included in pressure-contacted member

### (a) Alignment process

The pressure-contacted member 25 disposed on the stage device 5 is subjected to alignment by aligning the setting position of the pressure-contacted member 25 with the drive coordinates on the stage device 5 side by use of the alignment mechanism 3.

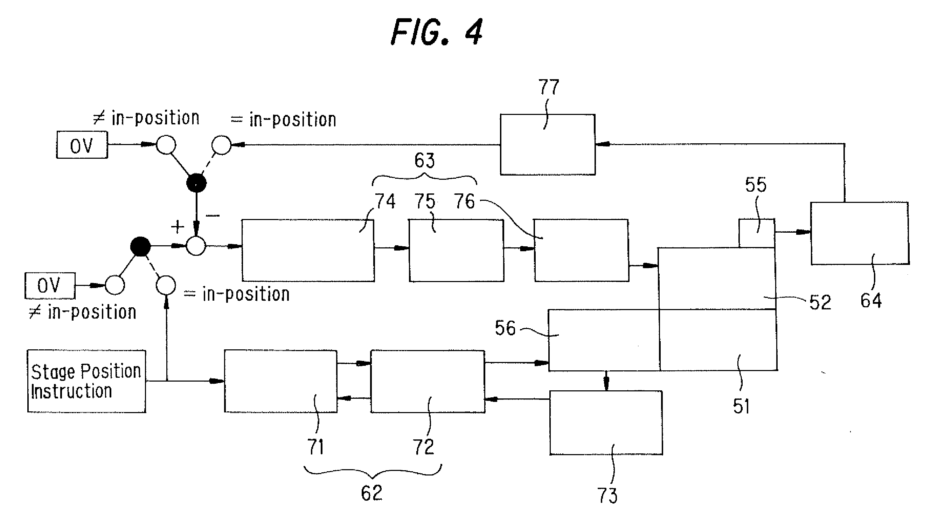

After alignment, the stage device 5 and the stage control unit 6 are controlled by a controlling method as shown in Figs. 3A to 3C and by a control block as shown in Fig. 4 in order to perform bonding of the pressure-contacting target member 24 and the thin film members of the pressure-contacted member 25 at high positioning accuracy. To be more precise, the rough motion stage 51 is controlled in a semi-closed mode by a motor control board 71 and a motor driver 72 collectively constituting the main control unit 62 of the stage control unit 6, and by use of a feedback signal from a rotary encoder 73 embedded in the motor 56. Meanwhile, the fine motion stage 52 is subjected to feedback control by a host fine motion control block 74, a DA converter board 75, and a PZT amplifier 76 collectively constituting the error correcting unit 63 of the stage control unit 6, an by use of a measured value measured by the laser length measuring machines 64 and calculated by a counter board 77.

### (b) Moving process

When a stage positioning instruction (the target position) is sent from the stage control unit 6, the motor 56 is driven by the motor control board 71 and the motor driver 72, and the rough motion stage 51 is thereby moved. At this time, the moving position of the rough motion stage 51 is measured by the rotary encoder 73. At the same time, the moving position is also measured by the laser length measuring machines 64. When the rough motion stage 51 is moving, a signal having a value of 0 V, i.e. no signal is sent to the error correcting unit 63 for controlling the fine motion stage 52, and the fine motion stage 52 maintains the current position. When it is judged that the rough motion stage 51 is moved into a range of the target position (an in-position state), in other words, when it is judged that the pressure-contacted member 25 is moved into a range of positioning accuracy of the rough stage 51 relative to target coordinates, the positioning of the rough motion stage 51 is completed and a driving shaft of the rough motion stage 51 is fixed by setting a brake to an ON state.

### (c) Measuring process, error correction process

Thereafter, the positioning process transits to a control mode for the fine motion stage 52 when the stage positioning instruction (the target position) from the stage control unit 6 is switched to the error correcting unit 63 side. In the error correcting unit 63, the position of the pressure-contacted member 25 moved by the rough motion stage 51 is measured by the laser length measuring machines 64. The error correcting unit 63 further obtains a difference by comparing the measured value sent from the laser length measuring machines 64 as the feedback and the stage positioning instruction (the target position), then calculates the error correction value based on the difference, and provides this error correction value to the piezoelectric elements of the fine motion stage 52 through the host fine motion control block 74, the D/A converter board 75, and the PZT amplifier 76. Accordingly, the fine motion stage 52 is moved to the target coordinates, and the positioning error caused by the rough motion state 51 is corrected. Thus, the positioning is performed at high accuracy.

That is, the positioning error of the rough motion stage 51 is corrected by moving the fine motion stage 52 in an amount equivalent to the positioning error caused by the rough motion stage 51. In this way, the positioning of the pressure-contacted member 25 to the target position is completed. Moreover, it is possible to perform the positioning at even higher accuracy by performing the correction while incorporating the flatness correction value of the mirror 55, the lamination correction value on the pressing rod 44, and a reference position correction value of the setting position of the pressure-contacted member 25, and the like into the foregoing error correction value. By using the above-described positioning method, it is possible to obtain a large stroke and high traveling speed by the rough motion stage 51, and to obtain high positioning accuracy by the fine motion stage 52 and the like. Therefore, when manufacturing the microstructure, it is possible to improve positioning accuracy of the thin film members of the pressure-contacted member 25 throughout a wide moving range. In this way, it is possible to achieve high accuracy of the shape of the microstructure formed by laminating multiple layers of the thin film members, and to improve fabrication efficiency at the same time.

### (4) Surface cleaning process for pressure-contacted member and pressure-contacting target member

After the positioning of the pressure-contacting target member 24 and the pressure-contacted member 25 is completed, the bonding surfaces of the pressure-contacting target member 24 and of the pressure-contacted member 25 are cleaned. Normally, oxide films attributable to reactions with oxygen in the air, residue of an etching material used in the photolithographic process, and other impurities exist on the bonding surfaces. Accordingly, in the manufacturing system for a microstructure of the present invention, neutral atomic beams, ion beams, and the like are irradiated from the FAB devices 22a and 22b onto the bonding surfaces in high vacuum (equal to or below 1 x 10⁻⁶ Pa) to remove these impurities from the bonding surfaces. In this way, the bonding surfaces are cleaned and set to a state where dangling bonds is allowed to exist thereon, that is, a state where the bonding surfaces are activated. Then, the bonding surfaces of the pressure-contacting target member 24 and of the pressure-contacted member 25 are pressure-contacted together. This process is called a room temperature bonding method. By bonding the members in accordance with the room temperature bonding method, the bonding surfaces thereof are bonded together by use of the dangling bonds existing thereon. In this way, it is possible to obtain fine bonding strength. Moreover, since it is possible to bond the members at a room temperature, distortion attributable to heat is avoided. Accordingly, this method also contributes to achieving high accuracy and highly efficient productivity.

### (5) Transferring (pressure-contacting and separating) process for pressure-contacted member and pressure-contacting target member

After cleaning of the bonding surfaces of the pressure-contacting target member 24 and of the pressure-contacted member 25 is completed, the bonding surfaces of the pressure-contacting target member 24 and of the pressure-contacted member 25 are subjected to pressure-contacting and separating. In this embodiment, pressure-contacting is performed by fixing a Z-axis position of the pressure-contacted member 25, and by moving the pressure-contacting target member 24 downward in the Z-axis direction with the pressure-contacting mechanism unit 4. The pressure-contacting force is measured with the dynamometer 46 in the course of pressure-contacting, whereby the bonding surfaces of the pressure-contacting target member 24 and of the pressure-contacted member 25 are bonded together while applying the optimum pressure-contacting force for the materials constituting the pressure-contacting target member 24 and the pressure-contacted member 25. Thereafter, when the pressure-contacting target member 24 is moved upward in the Z-axis direction, the thin film member on the pressure-contacted member 25 is peeled off and separated from the pressure-contacted member 25 and is transferred to the pressure-contacting target member 24.

### (6) Repeating process

In terms of each of the plurality of thin film members on the pressure-contacted member 25, the positioning process (3), the cleaning process (4) and the transferring process (5) are repeated. In this way, the plurality of thin film members are transferred to and laminated on the pressure-contacting target member 24, and eventually, the microstructure in the desired three-dimensional shape is formed.

Here, the manufacturing system for a microstructure according to the present invention can also use a pressure-contacted member in which a plurality of thin film members constituting one microstructure are formed on one substrate, a pressure-contacted member in which thin film members constituting different microstructures are formed respectively on one substrate, and the like. In this regard, the manufacturing system for a microstructure can also use a pressure-contacting target member in which a plurality of mesa-shaped portions (bonding portions) are formed thereon. In this way, it is possible to transfer plurality of thin film members to the plurality of bonding portions of the pressure-contacting target member (a batch process).

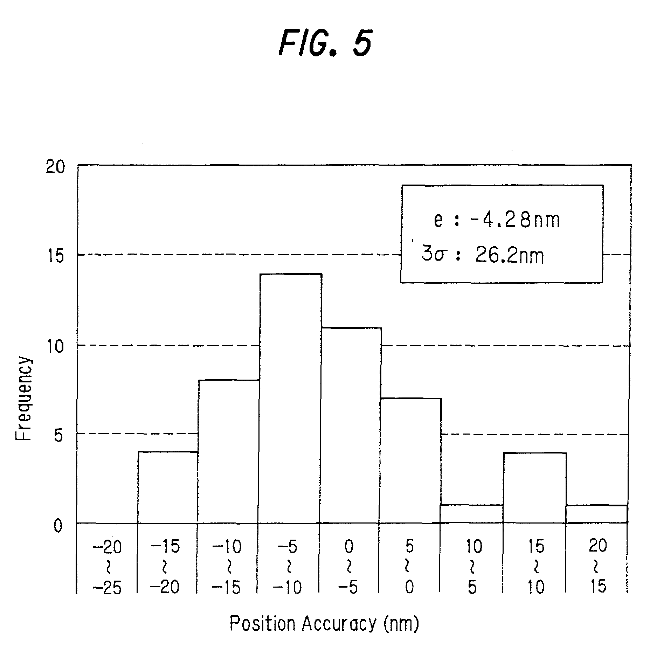

Fig. 5 shows a histogram of positioning accuracy in the case of using the manufacturing system for a microstructure according to the present invention.

This histogram shows represents a result when repeating operations for moving the rough motion stage 51 at stoke of 200 mm and performing error correction by the fine motion stage 52 for 100 times. As it is apparent from Fig. 5, the manufacturing system retained high positioning accuracy in spite of large stroke motion. This experiment marked high accuracy of the manufacturing system, namely, average deviation of e= -4.28 nm and standard deviation of σ= 26.2/3= 8.73 nm.

As the method of manufacturing a microstructure and a manufacturing system for the same according to the present invention uses the room temperature bonding method, the manufacturing system allows a wide range of lamination materials for forming microstructures. For example, in addition to metallic materials such as pure metal or alloys, it is possible to use various materials including dielectric materials, insulating materials, resin materials such as plastics, and the like. Moreover, as for the three-dimensional shape of the microstructure, it is possible to form various structures including an overhung structure, a hollow structure, and the like. For this reason, application of the microstructure manufactured by the manufacturing system is not only limited to micro machine parts such as micro gears. The microstructure is also applicable to wide range of products including micro systems having complicated shapes such as micro molds or micro channel elements, so-called micro machines, micro optical devices such as three-dimensional photonic crystals or diffractive optical elements, and the like.

## Claims

1. A method of manufacturing a microstructure, **characterized by** comprising:
a positioning step of opposing bonding portions of a pressure-contacted member (25) having a plurality of thin film members having any one of an arbitrary two-dimensional pattern and an arbitrary three-dimensional pattern and of a pressure-contacting target member (24) arranged so as to face the pressure-contacted member (25);
a pressure-contacting step of pressure-contacting the thin film members to the pressure-contacting target member (24) by pressure-contacting and separating means (4); and
a separating step of separating the thin film members toward the pressure-contacting target member (24) by the pressure-contacting and separating means (4), and
wherein each thin film member is laminated sequentially on the pressure-contacting target member (24) by repeating the positioning, pressure-contacting and separating steps, and
wherein the positioning step includes:
a motion step of moving any of the pressure-contacted member (25) and the pressure-contacting target member (24) to a target position by use of a first stage (51) having a stroke enabling the first stage (51) to travel across entire surfaces of the pressure-contacted member (25) and the pressure-contacting target member (24);
a measuring step of measuring a position of any of the pressure-contacted member (25) and the pressure-contacting target member (24), which is moved by the first stage (51), by measuring means (64) capable of measuring the position at high accuracy, and of calculating an error correction value based on difference between the measured position and a target position; and
an error correction step of moving a second stage, which has a stroke equivalent to or greater than a range of positioning accuracy of the first stage (51), to the target position based on the calculated error correction value, and of correcting a positioning error of the first stage (51).

2. The method of manufacturing a microstructure according to claim 1, wherein in the error correction step, the positioning error of the first stage (51) is corrected by use of the second stage (52) disposed so as to be capable of moving at least one of the pressure-contacted member (25) and the pressure-contacting target member (24).

3. The method of manufacturing a microstructure according to any one of claims 1 and 2, wherein in the error correction step, the second stage (52) is moved by use of a piezoelectric element for driving a movable portion of the second stage (52) and by use of an elastic guide for guiding the movable portion thereof.

4. The method of manufacturing a microstructure according to claim 3, wherein in the error correction step, the second stage (52) is inchworm-driven.

5. The method of manufacturing a microstructure according to any one of claims 1 through 4, wherein in the measuring step, by measuring a length up to a mirror (55) by use of a laser length measuring machine (65) measuring a length using a laser beam and by use of the mirror (55) moving so as to follow any of the pressure-contacted member (25) and the pressure-contacting target member (24), a position of any of the pressure-contacted member (25) and the pressure-contacting target member (24), which is moved by the first stage (51), is measured.

6. The method of manufacturing a microstructure according to claim 5, wherein in the measuring step, before a lamination of the pressure-contacted member (25) or during the lamination of the pressure-contacted member (25), a degree of flatness of a plane of the mirror (55) is measured, a flatness correction value is obtained based on the degree of flatness of the mirror (55) relative to an ideal plane of the mirror (55), and the error correction value is corrected by use of the flatness correction value.

7. The method of manufacturing a microstructure according to any one of claims 1 through 6, wherein in the positioning step,
a position of the pressure-contacting and separating means (4) for holding any of the pressure-contacted member (25) and the pressure-contacting target member (24) is measured,
during the lamination, a lamination correction value is calculated based on an amount of deviation from a position of the pressure-contacting and separating means (4) in a previous lamination, and
the error correction value is corrected by use of the lamination correction value.

8. The method of manufacturing a microstructure according to any one of claims 1 through 7, wherein the positioning step includes an alignment step in which a setting position of any of the pressure-contacted member (25) and the pressure-contacting target member (24) relative to a reference position for positioning the first and second stages (51, 52) is measured, and a reference position correction value for correcting the setting position to the reference position is calculated.

9. The method of manufacturing a microstructure according to claim 8, wherein in the alignment step, an alignment mark formed in any of the pressure-contacted member (25) and the pressure-contacting target member (24) is detected, and the setting position is obtained based on a detected position of the alignment mark.

10. The method of manufacturing a microstructure according to claim 9,
wherein in the alignment step,
a minute film pattern formed by use of a photolithographic technique is used as the alignment mark, and
an optical system capable of enlarging the alignment mark into an arbitrary size to project the enlarged alignment mark, photographing means for photographing the alignment mark through the optical system, and image processing means for recognizing the detection portion of the alignment mark from an image photographed by the photographing means are used.

11. The method of manufacturing a microstructure according to any one of claims 1 through 10, wherein a substrate in which any of a plurality of arbitrary two-dimensional patterns and a plurality of arbitrary three-dimensional patterns are formed is used as the pressure-contacting target member (24).

12. The method of manufacturing a microstructure according to 1 through 11, wherein a substrate in which any of a plurality of arbitrary two-dimensional patterns and a plurality of arbitrary three-dimensional patterns are formed is used as the pressure-contacted member (25).

13. The method of manufacturing a microstructure according to any one of claims 1 through 11, wherein any of the pressure-contacted member (25) and the pressure-contacting target member (24) is rendered replaceable.

14. The method of manufacturing a microstructure according to any one of claims 1 through 13, wherein in the pressure-contacting step, an operation accuracy of a pressure-contacting shaft is secured by use of the pressure-contacting shaft for holding any of the pressure-contacted member (25) and the pressure-contacting target member (24) and by use of guiding means having one or a plurality of linear motion guiding mechanisms disposed parallel to a pressure-contacting direction of the pressure-contacting shaft, so as to suppress movement of the pressure-contacting shaft in a direction perpendicular to a pressure-contacting direction.

15. A manufacturing system for a microstructure, **characterized by** comprising:
pressure-contacting and separating element (4) for pressure-contacting a pressure-contacted member (25) having a plurality of thin film members, each having any of an arbitrary two-dimensional pattern and an arbitrary three-dimensional pattern, to a pressure-contacting target member (24) arranged so as to face the pressure-contacted member (25), and for separating the thin film members toward the pressure-contacting target member (24); and
positioning element (6) for performing positioning of the pressure-contacted member (25) and the pressure-contacting target member (25),
wherein bonding portions of the pressure-contacted member (25) and of the thin film members are opposed to one another by the positioning element (6), the thin film members are pressure-contacted to the pressure-contacting target element (24) by the pressure-contacting and separating element (4), and the pressure-contacting and separating element (4) separates from the pressure-contacting target element (24), thus laminating the thin film members on the pressure-contacting target member (24), and
wherein the positioning element (6) comprises:
a first stage (51)having a stroke enabling the first stage to travel across entire surfaces of the pressure-contacted member (25) and the pressure-contacting target member (24) facing each other;
a second stage (52) having a stroke equivalent to or greater than a range of positioning accuracy of the first stage (51);
measuring element (64) capable of measuring a position of at least one of the pressure-contacted member (25) and the pressure-contacting target member (24) at high accuracy; and
positioning controlling element for allowing the measuring element (64) to measure the position of any of the pressure-contacted member (25) and the pressure-contacting target member (24) moved by the first stage (51), for calculating an error correction value based on a difference between the measured position and a target position, and for moving the second stage (52) to the target position by use of the calculated error correction value, thus correcting a positioning error of the first stage (51).

16. The manufacturing system for a microstructure according to claim 15, wherein at least one of the pressure-contacted member (25) and the pressure-contacting target member (25) is disposed movably in the second stage (52).

17. The manufacturing system for a microstructure according to any one of claims 15 and 16, wherein the second stage (52) includes a piezoelectric element (52d, 52e) for driving a movable portion thereof and an elastic guide for guiding the movable portion.

18. The manufacturing system for a microstructure according to claim 17, wherein the second stage is inchworm-driven.

19. The manufacturing system for a microstructure according to any one of claims 15 through 18, wherein the measuring element (64) includes a laser length measuring machine measuring a length using a laser beam and a mirror moving so as to follow any of the pressure-contacted member (25) and the pressure-contacting target member (24), and the measuring element (64) measures a length up to the mirror (55), thus measuring a position of any of the pressure-contacted member (25) and the pressure-contacting target member (24), which is moved by the first stage (51).

20. The manufacturing system for a microstructure according to claim 19, wherein measuring element (64) includes mirror correction element for measuring a degree of flatness of a plane of the mirror, for obtaining a flatness correction value based on the degree of flatness of the mirror (55) relative to an ideal plane of the mirror (55), and for correcting the error correction value by use of the flatness correction value, before a lamination of the pressure-contacted member (25) or during the lamination of the pressure-contacted member (25).

21. The manufacturing system for a microstructure according to any one of claims 15 through 20, wherein the positioning element (6) includes a lamination correction element which measures a position of the pressure-contacting and separating element (4) for holding any of the pressure-contacted member (25) and the pressure-contacting target member (24) by the measuring element (64), calculates a lamination correction value, during the lamination, based on an amount of deviation from a position of the pressure-contacting and separating element (4) in a previous lamination, and corrects the error correction value by use of the lamination correction value.

22. The manufacturing system for a microstructure according to any one of claims 15 through 21, wherein the positioning element (6) includes alignment element (23) for measuring a setting position of any of the pressure-contacted member (25) and the pressure-contacting target member (24) relative to a reference position for positioning the first and second stages (51, 52), and for calculating a reference position correction value for correcting the setting position to the reference position.

23. The manufacturing system for a microstructure according to claim 22, wherein the alignment element (23) detects an alignment mark formed in any of the pressure-contacted member (25) and the pressure-contacting target member (24), and obtains the setting position based on a detection position of the alignment mark.

24. The manufacturing system for a microstructure according to 23,
wherein the alignment mark is formed as a minute film pattern formed by use of a photolithographic technique, and
the alignment element includes an optical system capable of enlarging the alignment mark into an arbitrary size to project the enlarged alignment mark, photographing element for photographing the alignment mark through the optical system, and image processing element for recognizing the detection portion of the alignment mark from an image photographed by the photographing element.

25. The manufacturing system for a microstructure according to any one of claims 15 through 24, wherein a substrate in which any one of a plurality of arbitrary two-dimensional patterns and a plurality of arbitrary three-dimensional patterns are formed is used as the pressure-contacted member (25).

26. The manufacturing system for a microstructure according to any one of claims 15 through 25, wherein a substrate in which any one of a plurality of arbitrary two-dimensional patterns and a plurality of arbitrary three-dimensional patterns are formed is used as the pressure-contacting target member (24).

27. The manufacturing system for a microstructure according to any one of claims 15 through 25, in which any one of the pressure-contacted member (25) and the pressure-contacting target member (24) is rendered replaceable.

28. The manufacturing system for a microstructure according to any one of claims 15 through 27, in which the pressure-contacting and separating element (4) includes a pressure-contacting shaft for holding any of the pressure-contacted member (25) and the pressure-contacting target member (24), and guiding element composed of one or a plurality of linear motion guiding mechanisms disposed parallel to a pressure-contacting direction of the pressure-contacting shaft, so as to suppress movement of the pressure-contacting shaft in a direction perpendicular to a pressure-contacting direction.
